# EUROPEAN PATENT SPECIFICATION

(11) **EP 2 165 358 B1**
(45) Date of publication and mention of the grant of the patent: **17.08.2011**
(21) Application number: 08771365.7
(22) Date of filing: 18.06.2008
(51) Int. Cl.: H01L 21/68

(54) **SUSCEPTOR FOR IMPROVING THROUGHPUT AND REDUCING WAFER DAMAGE**
SUSZEPTOR ZUR ERHÖHUNG DES DURCHSATZES UND ZUR MINIMIERUNG VON WAFERBESCHÄDIGUNG
SUSCEPTEUR POUR AMÉLIORER LE DÉBIT ET RÉDUIRE UN ENDOMMAGEMENT DES TRANCHES

(30) Priority: 19.06.2007 US 944910 P; 27.12.2007 US 965506
(43) Date of publication of application: 24.03.2010
(73) Proprietor: MEMC Electronic Materials, Inc., St. Peters, MO 63376 (US)
(72) Inventor: HAMANO, Manabu, Tochigi Prefecture 321-0912 (JP); KOMMU, Srikanth, St. Charles, Missouri 63303 (US); PITNEY, John A., St. Peters, Missouri 63376 (US); TORACK, Thomas A., St. Louis, Missouri 63122 (US); HELLWIG, Lance G., Florissant, Missouri 63031 (US)
(74) Representative: Maiwald, Walter
(86) International application number: PCT/US2008/067344
(87) International publication number: WO 2008/157605

(56) References cited:
- WO-A-2006/058847
- JP-A- 2000 133 187
- US-A1- 2006 201 623
- US-A1- 2006 291 835

## Description

### Background

This invention according to claim 1 relates to a susceptor for use in a chemical vapor deposition process, and more particularly to a susceptor for supporting a single semiconductor wafer during a chemical vapor deposition process.

Semiconductor wafers may be subjected to a chemical vapor deposition process such as an epitaxial deposition process to grow a thin layer of silicon on the front surface of the wafer. This process allows devices to be fabricated directly on a high quality epitaxial layer. Conventional epitaxial deposition processes are disclosed in U.S. Patent Nos. 5,904,769 and 5,769,942, which are incorporated herein by reference.

Prior to epitaxial deposition, the semiconductor wafer is loaded into a deposition chamber and lowered onto a susceptor. After the wafer is lowered onto the susceptor, the epitaxial deposition process begins by introducing a cleaning gas, such as hydrogen or a hydrogen and hydrochloric acid mixture, to a front surface of the wafer (i.e., a surface facing away from the susceptor) to pre-heat and clean the front surface of the wafer. The cleaning gas removes native oxide from the front surface, permitting the epitaxial silicon layer to grow continuously and evenly on the surface during a subsequent step of the deposition process. The epitaxial deposition process continues by introducing a vaporous silicon source gas, such as silane or a chlorinated silane, to the front surface of the wafer to deposit and grow an epitaxial layer of silicon on the front surface. A back surface opposite the front surface of the susceptor may be simultaneously subjected to hydrogen gas. The susceptor, which supports the semiconductor wafer in the deposition chamber during the epitaxial deposition, is rotated during the process to ensure the epitaxial layer grows evenly. Prior art susceptors used in epitaxial growth processes are described in U.S. Patent Nos. 6,652,650.

A common susceptor design includes a disk having a recess with a concave floor. This shape allows the wafer to contact the susceptor at its edge while the remainder of the wafer does not contact the susceptor. If the semiconductor wafer contacts the susceptor at a point other than at its edge, defects can occur at these contact points if the wafer rests on a silicon carbide coating on the susceptor. These defects may lead to front surface dislocations and slip and have the potential to cause device failure.

A common susceptor having a recess with a concave or jagged and stair-step configuration is described in US 2006/291835 A1.

Another stair-step configuration is mentioned in JP 2000 133187. This configuration has the purpose of accommodating many different sized wafers on a sample stage of an electron microscope.

Applicants have discovered that portions of the wafer other than those the wafer edge can contact the susceptor shortly after the wafer is loaded onto the susceptor. The semiconductor wafer is typically near ambient temperature when it is loaded on the susceptor. In contrast, the susceptor is at a temperature between about 500°C and about 1000°C when the wafer is loaded on the susceptor. The temperature difference between the wafer and the susceptor causes the wafer to heat rapidly and bow. The bowing can cause the back surface of the wafer to contact the susceptor, causing defects at the contact points, especially near the center of the wafer.

One approach to prevent wafer back surface damage is to use a susceptor having a more concave floor. This shape increases the distance between the back surface of the wafer and the susceptor. However, it has been discovered that increasing the concavity of the floor causes an increase in wafer slip locations at the wafer edge. Because the mass of the susceptor is significantly larger than the mass of the semiconductor wafer, the wafer temperature generally increases uniformly across the wafer when loaded on the susceptor. However, if the depth of the center of the recess is significantly greater than the depth toward the edge of the recess, radial temperature gradients can form across the wafer. These temperature gradients can result in slip and dislocations in the wafer, especially at the wafer edge.

Another problem presented by conventional susceptors is that susceptors take a long time to heat up and cool down causing increased processing time. Further, because conventional susceptors are solid beneath the entire wafer, they block hydrogen from reaching the wafer back surface to remove native oxide and block outdiffused dopant from the wafer back surface from escaping.

Thus, a need exits for susceptors that reduce or eliminate wafer back surface defects and minimize occurrence of slip dislocations in the wafer. Further, there is a need for a susceptor that reduces processing time by allowing the susceptor to heat up and cool down faster, that allows hydrogen to reach the wafer back surface and that allows outdiffused dopant to escape from the back surface of the wafer.

### Summary

One aspect of the present invention is directed to a susceptor for supporting a semiconductor wafer in a heated chamber having an interior space. The wafer has a front surface, a back surface opposite the front surface and a circumferential side extending around the front surface and the back surface. The susceptor is sized and shaped for receipt within the interior space of the chamber and for supporting the semiconductor wafer. The susceptor comprises a body having an upper surface and a lower surface opposite the upper surface. Further, the susceptor includes a recess extending downward from the upper surface into the body along an imaginary central axis. The recess is sized and shaped for receiving the semiconductor wafer therein. In addition, the susceptor comprises a plurality of lift pin openings extending through the body from the recess to the lower surface. Each of the plurality of the lift pin openings is sized for accepting lift pins to selectively lift and lower the wafer with respect to the recess. Moreover, the susceptor includes a central opening extending through the body along the central axis from the recess to the lower surface.

Another aspect of the present invention is directed to a susceptor for supporting a semiconductor wafer in a heated chamber having an interior space. The wafer has a front surface, a back surface opposite the front surface and a circumferential side extending around the front surface and the back surface. The susceptor is sized and shaped for receipt within the interior space of the chamber and for supporting the semiconductor wafer. The susceptor comprises a body having an upper surface and a lower surface opposite the upper surface. Further, the susceptor includes a recess extending downward from the upper surface into the body along an imaginary central axis. The recess includes a wafer-engaging face sized and shaped for receiving the semiconductor wafer thereon. The susceptor also has a central opening extending through the body along the central axis from the recess to the lower surface.

In yet another aspect, the present invention includes a susceptor for supporting a semiconductor wafer in a heated chamber having an interior space. The wafer has a front surface, a back surface and a circumferential edge. The susceptor is sized and shaped for supporting the semiconductor wafer within the interior space of the chamber. The susceptor comprises an upper surface and a first recess extending downward from the upper surface. The first recess is adapted to receive the semiconductor wafer. The first recess includes a generally annular first wall and a first ledge extending from the first wall toward a center of the recess. The first ledge has an outer perimeter and an inner perimeter. The first ledge has a downward slope from the outer perimeter to the inner perimeter to facilitate supporting the wafer. The susceptor also comprises a second recess extending downward from the first recess. The second recess includes a generally annular second wall and a second ledge extending inward from the second wall/ Further, the susceptor includes a third recess extending downward from the second recess. The third recess includes a generally annular third wall and a floor extending inward from the third wall. The first, second and third recesses have a common central axis.

Still a further aspect of the present invention includes a susceptor for supporting a semiconductor wafer in a chamber having an interior space, a gas inlet for directing process gas to flow into the interior space of the chamber and a gas outlet through which process gas is exhausted from the interior space of the chamber. The wafer has a front surface, a back surface and a circumferential edge. The susceptor is sized and shaped for supporting the semiconductor wafer within the interior space of the chamber. The susceptor comprises an upper surface and a first recess extending downward from the upper surface. The first recess is adapted to receive the semiconductor wafer. Further, the first recess includes a generally annular first wall and a first ledge extending from the first wall toward a center of the recess. The first ledge has an outer perimeter and an inner perimeter. In addition, the susceptor comprises a second recess extending downward from the first recess. The second recess includes a generally annular second wall and a second ledge extending inward from the second wall. Still further, the susceptor includes a third recess extending downward from the second recess. The third recess includes a generally annular third wall and a floor extending inward from the third wall. The distance between the back surface of the wafer and the floor of the third recess is between about 0.005 inches and about 0.030 inches to inhibit contact of the wafer with the susceptor except adjacent the edge of the wafer as the wafer warps during heating.

The present invention also includes a susceptor for supporting a semiconductor wafer in a chamber having an interior space, a gas inlet for directing process gas to flow into the interior space of the chamber and a gas outlet through which process gas is exhausted from the interior space of the chamber. The wafer has a front surface, a back surface and a circumferential edge. The susceptor is sized and shaped for supporting the semiconductor wafer within the interior space of the chamber. Further, the susceptor comprises an upper surface and a wafer-receiving recess extending downward from the upper surface. The recess includes a ledge for supporting the wafer. Still further, the susceptor comprises a central recess coaxial with the wafer-receiving recess and extending deeper into the susceptor than the wafer-receiving recess. The ratio of the surface area of the wafer-receiving recess to the surface area of the central recess is at least about 13 to about 1 to minimize slip.

Various refinements exist of the features noted in relation to the above-mentioned aspects of the present invention. Further features may also be incorporated in the above-mentioned aspects of the present invention as well. These refinements and additional features may exist individually or in any combination. For instance, various features discussed below in relation to any of the illustrated embodiments of the present invention may be incorporated into any of the above-described aspects of the present invention, alone or in any combination.

### Brief Description of Drawings

Fig. 1 is a cross section of a susceptor of a first embodiment supporting a semiconductor wafer;

Fig. 2 is a cross section of the susceptor of Fig. 1 supporting a bowed semiconductor wafer;

Fig. 3 is a top view of the susceptor of Fig. 1;

Fig. 4 is a schematic cross section of the susceptor of Fig. 1 supporting a semiconductor wafer in a chamber

Fig. 5 is a top view of a susceptor of a second embodiment;

Fig. 6 is a partial cross section of the susceptor of Fig. 5 supporting a semiconductor wafer;

Fig. 7 is a top view of a susceptor of a third embodiment; and

Fig. 8 is a partial cross section of the susceptor of Fig. 7 supporting a semiconductor wafer.

Corresponding reference characters indicate corresponding parts throughout the drawings.

### Detailed Description of Exemplary Embodiments

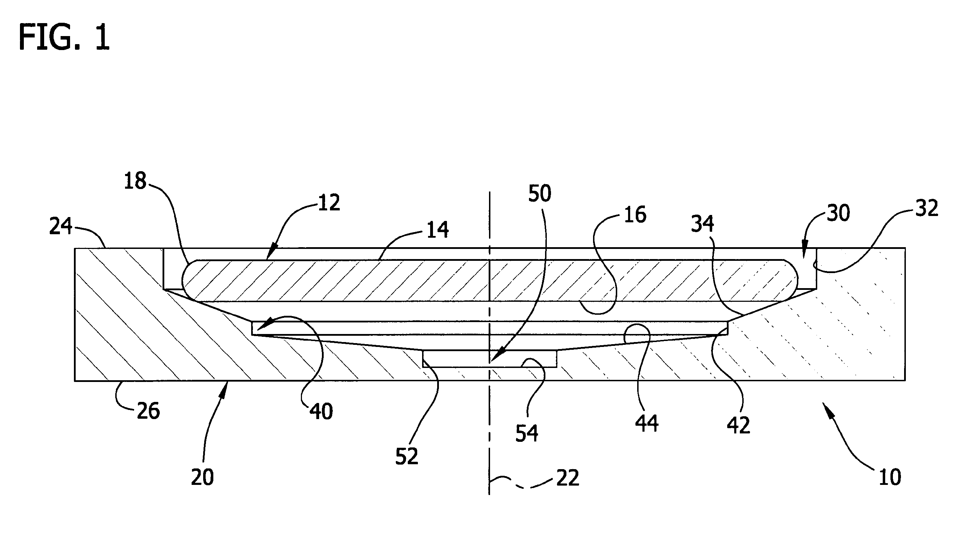

Referring now to the drawings, and in particular Fig. 1, a susceptor is generally indicated in its entirety by the reference number 10. The susceptor 10 supports a semiconductor wafer, generally designated by 12. The wafer 12 has a front surface 14 and a back surface 16 opposite the front surface. The wafer 12 also has a circumferential side 18 extending around the front surface 14 and the back surface 16. Although the circumferential side 18 shown in Fig. 1 is generally rounded, the side may be straight without departing from the scope of the present invention.

The susceptor 10 includes a body, generally designated by 20, having a circular shape surrounding an imaginary central axis 22. Further, the body 20 includes an upper surface 24 and a lower surface 26. A first or outer recess, generally designated by 30, extends downward into the body 20 from the upper surface 24. The first recess 30 includes a generally cylindrical wall 32 and a face 34 extending inward from a lower end of the wall 32. The face 34 also slopes downward from the wall 32 toward the central axis 22 of the body 20. The face 34 supports the wafer 12. As shown in Fig. 1, the downward slope of the face 34 results in narrow line of contact between the wafer 12 and the face. Although the face 34 may have other widths without departing from the scope of the present invention, in one embodiment the face has a width of about six millimeters (mm). In this embodiment, the wafer 12 contacts the face 34 along the circumferential side 18 near the back surface 16 of the wafer.

As further shown in Fig. 1, the susceptor 10 also includes a second or middle recess 40 extending downward into the body 20 from the first recess 30. The second recess 40 includes a generally cylindrical wall 42 and a face 44 extending inward toward the central axis 22 from a lower end of the wall 42. Although the second face 44 is shown as being linearly sloped, the second ledge may be generally concave without departing from the scope of the present invention. According to one embodiment, the height of the wall 42 is between about 0.002 inch (0.05 mm) and about 0.003 inch (0.08 mm).

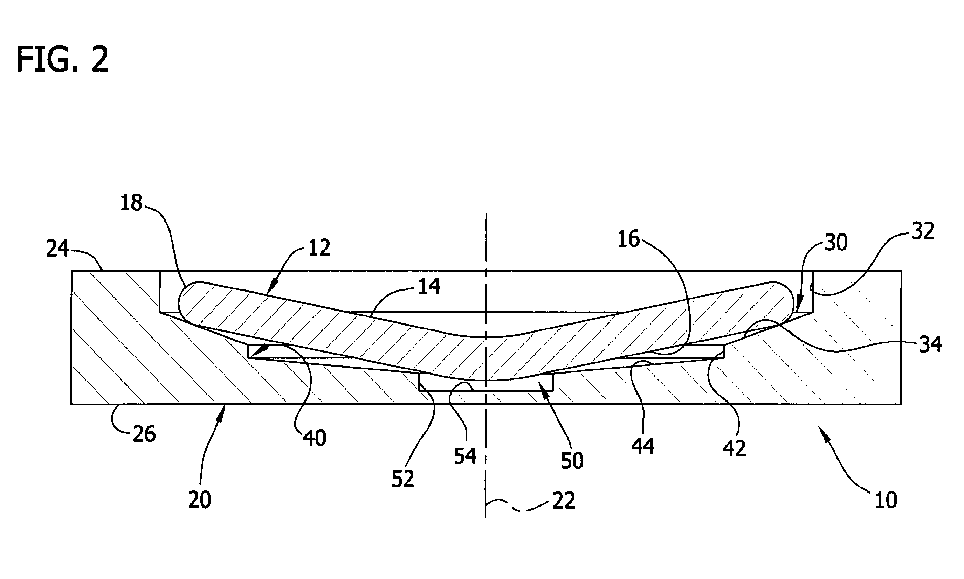

A third or inner recess 50 extends downward into the body 10 from the second recess 40. The third recess 50 includes a cylindrical wall 52 and a floor 54 extending inward from the wall to the central axis 22. According to one embodiment, the height of the wall 52 is about 0.003 inch (0.08 mm). As will be appreciated by those skilled in the art, the third recess 50 prevents the back surface 16 of the wafer 12 near the center of the wafer from contacting the susceptor 10 when the wafer bows downward due to thermal gradients as shown in Fig. 2. Although the floor 54 may have other shapes without departing from the scope of the present invention, in one embodiment the floor 54 is generally flat.

It has been found that wafers supported on susceptors in which a vertical distance between the bottom of the second wall 42 and the top of the third wall 52 is greater than about 0.010 inch (0.25 mm) typically have an unacceptable amount of wafer slip dislocations at the wafer edge. Thus, according to one embodiment, the vertical distance between the bottom of the second wall 42 and the top of the third wall 52 is not greater than about 0.007 inch (0.18 mm). According to another embodiment, this distance is not greater than about 0.005 inch (0.10 mm).

According to a further embodiment, the distance between the back surface 16 of the unbowed wafer 12 and the floor 54 of the third recess 50 is between about 0.005 inch (0.13 mm) and about 0.030 inch (0.76 mm). If the distance between the wafer 12 and the floor 54 is at least about 0.005 inch (0.13 mm), wafers without surface damage near the center of the back surface 16 wafer may be produced. If the distance between the wafer 12 and the floor 54 is less than about 0.030 inch (0.76 mm), wafers without a significant number of slip dislocations may be produced. According to another embodiment, the distance between the back surface 16 of the unbowed wafer 12 and the floor 54 of the third recess 50 is between about 0.008 inch (0.20 mm) and about 0.030 inch (0.76 mm) and in another embodiment this distance is between about 0.010 inch (0.25 mm) and about 0.030 inch (0.76 mm).

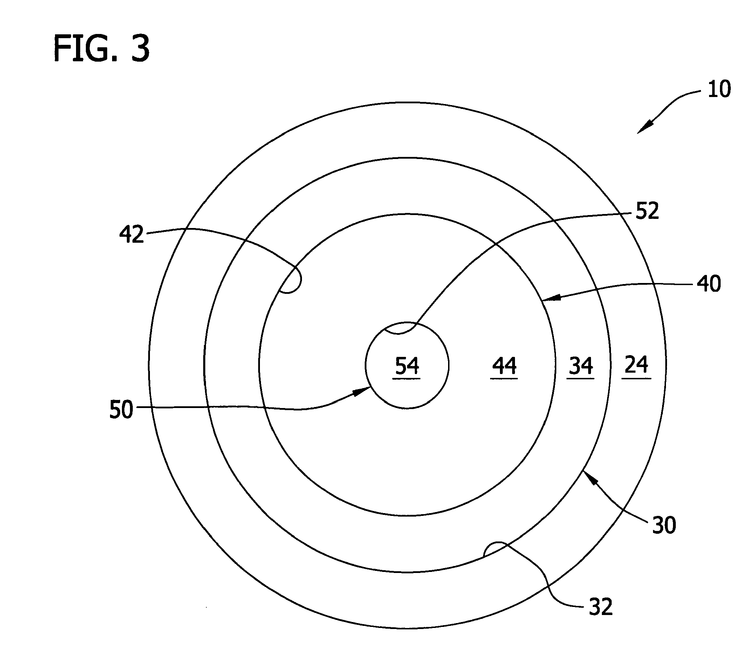

The three recesses 30, 40, 50 are generally circular and are centered on the imaginary central axis 22 as shown in Fig. 3. Typically, the recesses 30, 40, 50 do not extend through the susceptor 10 to the lower surface 26 of the susceptor. However, according to one embodiment the third recess 50 extends through an entire thickness of the susceptor 10.

The middle recess 40 should be sufficiently large to prevent contact between the back surface 16 of the wafer 12 and the susceptor 10 during heating of the semiconductor wafer. However, the middle recess 40 should not be so large that more of the susceptor mass is removed than is necessary to prevent contact. The susceptor should enable the wafer temperature to increase uniformly upon loading the wafer 12 on the susceptor 10. Thus, according to one embodiment, the ratio of the surface area of the outer recess 30 to the surface area of the middle recess 40 is at least about 13:1 to minimize wafer slip.

Although the susceptor 10 may have other overall dimensions without departing from the scope of the present invention, in one embodiment the susceptor has an overall diameter of about 14.7 inches and an overall thickness of about 0.15 inch. Further, although the susceptor 10 may be made of other materials without departing from the scope of the present invention, in one embodiment the susceptor is made of silicon carbide coated graphite. The susceptor 10 may have a plurality of holes extending from the upper surface 14 to the lower surface 16 as shown and described in U.S. Patent Nos. 6,652,650 and 6,444,027.

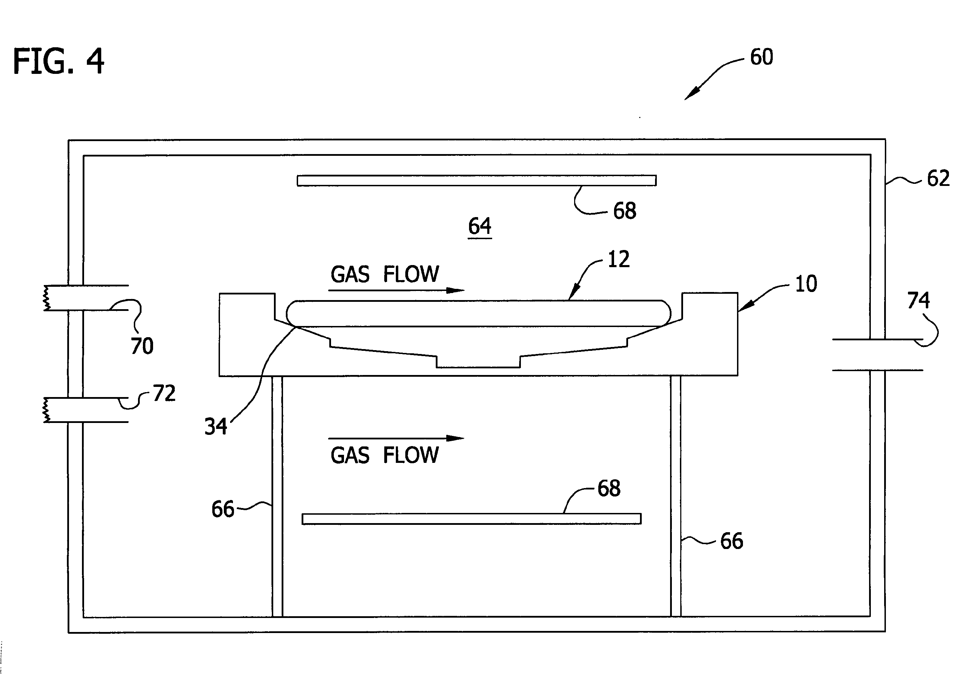

The susceptor 10 described above may be used as part of an apparatus for chemical vapor deposition processes such as an epitaxial deposition process. Referring now to Fig. 4, apparatus for chemical vapor deposition processes is generally designated by 60. The apparatus 60 includes an epitaxial reaction chamber 62 having an interior volume or space 64. The susceptor described above is sized and shaped for receipt within the interior space 64 of the chamber 62 and for supporting the semiconductor wafer 12. The susceptor 10 is attached to conventional rotatable supports 66 for rotating the susceptor during the epitaxial process. The reaction chamber 62 also contains a heat source, for example heating lamp arrays 68 located above and below the susceptor 10 for heating the wafer 12 during an epitaxial deposition process. An upper gas inlet 70 and lower gas inlet 72 allow gas to be introduced into the interior space 64 of the chamber 12.

During the epitaxial deposition process, an epitaxial silicon layer grows on the front surface 14 of the semiconductor wafer 12. The wafer 12 is introduced into the chamber 62 and centered on the face 34 of the susceptor 10. The wafer 12 bows as it heats to the temperature of the susceptor 10. First the apparatus performs a pre-heat or cleaning step. A cleaning gas, such as hydrogen or a mixture of hydrogen and hydrochloric acid, is introduced into the chamber 62 at about ambient pressure, at a temperature between about 1000°C and about 1250°C, and at a flow rate between about five liters per minute and about 100 liters per minute. After a period of time sufficient to remove native oxide layers from both the front and back surfaces of the wafer 12 and to stabilize the temperature in the reaction chamber 62 between about 1000°C and about 1250°C, a silicon-containing source gas, such as silane or a chlorinated silane, is introduced through the inlet 60 above the front surface 14 of the wafer 12 at a flow rate between about one liter per minute and about fifty liters per minute. The source gas flow continues for a period of time sufficient to grow an epitaxial silicon layer on the front surface 14 of the wafer 12 to a thickness between about 0.1 micrometer and about 200 micrometers. Simultaneously with the source gas being introduced, a purge gas, such as hydrogen, flows through the inlet 72 below the back surface 16 of the wafer 12. The purge gas flow rate is selected so the purge gas contacts the back surface 16 of the semiconductor wafer 12, reduces native oxide, and carries out-diffused dopant atoms from the back surface to an exhaust outlet 74 at a flow rate between about five liters per minute and about 100 liters per minute.

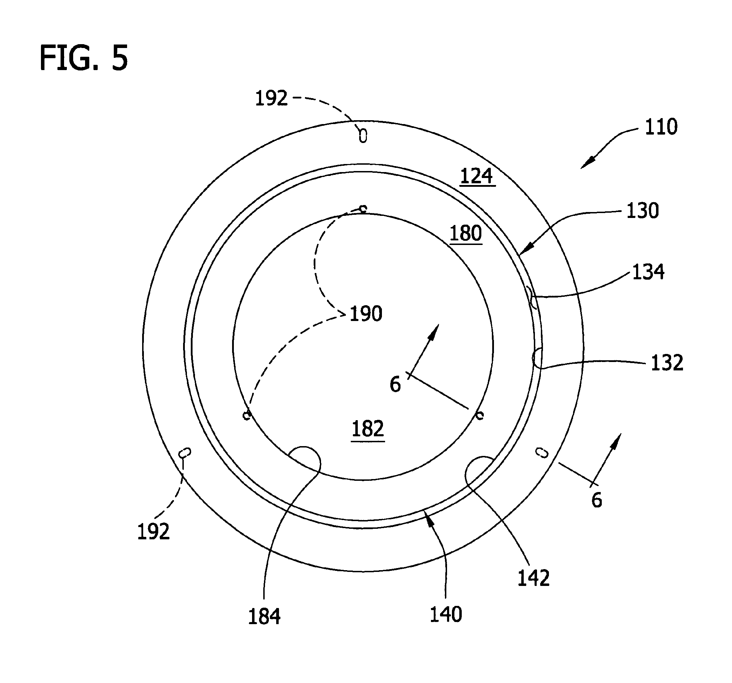

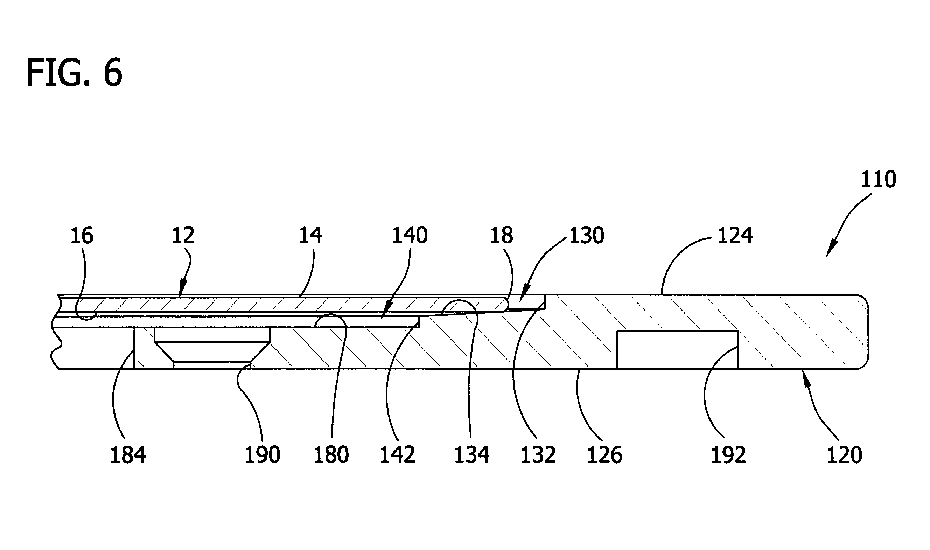

Referring to Figs. 5 and 6, another embodiment of the susceptor of the present invention is generally indicated at 110. Because the susceptor is similar to the susceptor of the previous embodiment, like components will be indicated by corresponding reference numerals incremented by 100. The susceptor 110 includes an annual body, generally designated by 120, having a circular shape surrounding an imaginary central axis 122. Further, the body 120 includes an upper surface 124 and a lower surface 126. A first recess, generally designated by 130, extends downward into the body 120 from the upper surface 124. The first recess 130 includes a generally cylindrical wall 132 and a face 134 extending inward from a lower end of the wall 132. The face 134 also slopes downward from the wall 132 toward the central axis 122 of the body 120. The face 134 supports the wafer 12 (Fig. 6). Although the face 134 may have other widths without departing from the scope of the present invention, in one embodiment the face has a width of about six millimeters (mm). Although the wall 132 may have other heights without departing from the scope of the present invention, in one embodiment the wall has a height of about 0.027 inch. The susceptor 110 also includes a concave surface 180 inside the face 134. Although the surface 180 may have other widths without departing from the present invention, in one embodiment the surface has a width of about 1.38 inches.

As further illustrated in Fig. 5, the susceptor 110 also includes an opening 182 extending through the body 20. In one embodiment, the opening extends completely through the body 20 as a circular hole. As will be appreciated by those skilled in the art, the opening 182 prevents the back surface 16 (Fig. 6) of the wafer 12 near the center of the wafer from contacting the susceptor 110 when the wafer bows downward due to thermal gradients. Although the opening 182 may have other dimensions without departing from the scope of the present invention, in one embodiment the opening has a diameter of about 8.66 inches. According to one embodiment, the opening 182 is defined by a wall 184 having a height between about 0.10 inch and about 0.11 inch. As other features of the susceptor 110 of this embodiment are identical to the susceptor described previously, they will not be described in further detail.

As shown in Figs. 5 and 6, three equally spaced holes 190 extend through the susceptor 110 at the surface 180. These holes 190 receive conventional lift pins (not shown) to raise the wafer 12 above the susceptor and lower it onto the susceptor during processing. As these holes 190 and the lift pins are well known in the art, they will not be described in further detail. In addition, three equally spaced, race-track-shaped openings 192 extend into the susceptor 110 from the lower surface 126 for receiving the upper ends of conventional rotatable supports 66 described above with respect to Fig. 4. These openings 192 engage the supports 66 to prevent the susceptor 110 from slipping on the supports 66 as they turn during processing. Because these openings 192 are conventional, they will not be described in further detail.

Conventional susceptors heat up and cool down slowly. For example, a conventional susceptor may take as much as 25 seconds to reach a steady state temperature when heated from about 700°C to about 1150°C. Further, the temperature gradient across a conventional susceptor may exceed 50°C or more during heating. In contrast, a susceptor 110 as described above heats up and cools down much more quickly. For example, a susceptor may reach steady state in about 10 seconds when heated from about 700°C to about 1150°C, and the temperature gradient may never exceed 20°C during heating.

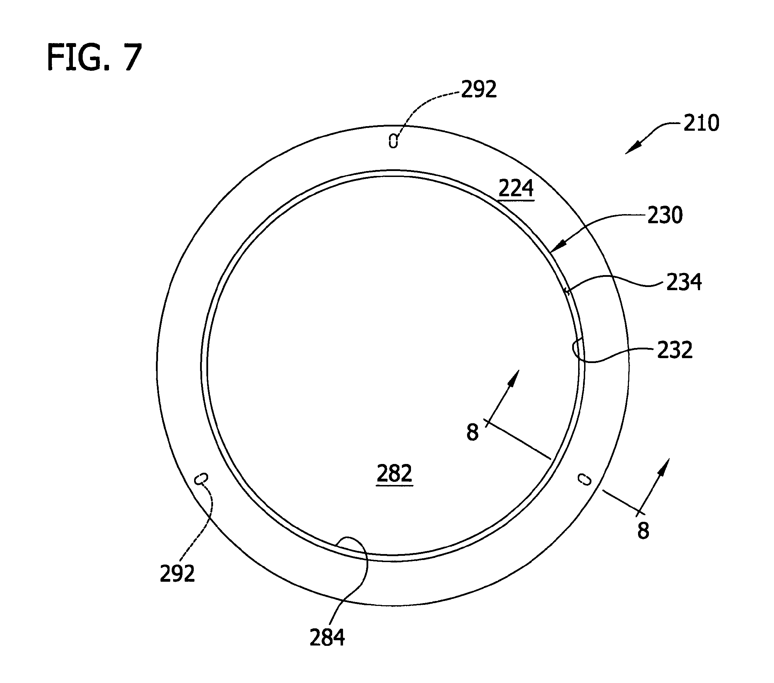

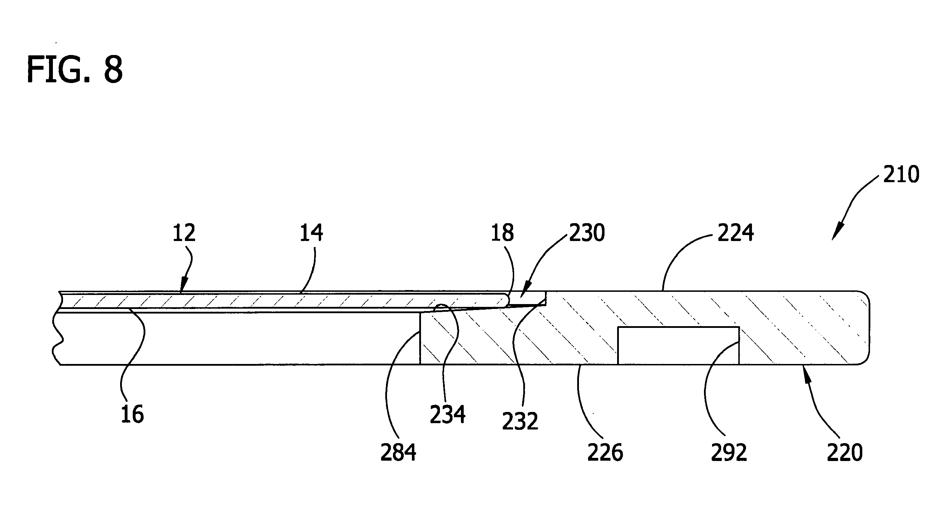

Referring to Figs. 7 and 8, yet another embodiment of the susceptor of the present invention is generally indicated at 210. Because the susceptor is similar to the susceptor of Figs. 5 and 6, like components will be indicated by corresponding reference numerals incremented by 100. The susceptor 210 includes an annual body, generally designated by 220, having a circular shape surrounding an imaginary central axis 222. Further, the body 220 includes an upper surface 224 and a lower surface 226. A recess, generally designated by 230, extends downward into the body 220 from the upper surface 224. The recess 230 includes a generally cylindrical wall 232 and a face 234 extending inward from a lower end of the wall 232. The face 234 slopes downward from the wall 232 toward the central axis 222 of the body 220. The face 234 supports the wafer 12 (Fig. 8). Although the face 234 may have other widths without departing from the scope of the present invention, in one embodiment the face has a width of about 6.4 mm. Although the wall 232 may have other heights without departing from the scope of the present invention, in one embodiment the wall has a height of about 0.027 inch. As further illustrated in Fig. 7, the susceptor 210 also includes an opening 282 extending through the body 20. In one embodiment, the opening extends completely through the body 20 as a circular hole. As will be appreciated by those skilled in the art, the opening 282 prevents the back surface 16 (Fig. 6) of the wafer 12 near the center of the wafer from contacting the susceptor 110 when the wafer bows downward due to thermal gradients. Although the opening 282 may have other dimensions without departing from the scope of the present invention, in one embodiment the opening has a diameter of about 5.774 inches. According to one embodiment, the opening 282 is defined by a wall 284 having a height between about 0.111 inch and about 0.115 inch. As other features of the susceptor 210 of this embodiment are identical to the susceptor 110 described previously, they will not be described in further detail. As shown in Figs. 7 and 8, three equally spaced, race-track-shaped openings 292 extend into the susceptor 210 from the lower surface 226 for receiving the upper ends of conventional rotatable supports 66 described above with respect to Fig. 4. These openings 292 engage the supports 66 to prevent the susceptor 210 from slipping on the supports 66 as they turn during processing. Because these openings 292 are conventional, they will not be described in further detail.

When introducing elements of various aspects of the present invention or embodiments thereof, the articles "a", "an", "the" and "said" are intended to mean that there are one or more of the elements. The terms "comprising", "including" and "having" are intended to be inclusive and mean that there may be additional elements other than the listed elements. Moreover, the use of "top" and "bottom", "front" and "rear", "above" and "below" and variations of these and other terms of orientation is made for convenience, but does not require any particular orientation of the components.

As various changes could be made in the above constructions, methods and products without departing from the scope of the invention, it is intended that all matter contained in the above description or shown in the accompanying drawings shall be interpreted as illustrative and not in a limiting sense. Further, all dimensional information set forth herein is exemplary and is not intended to limit the scope of the invention.

## Claims

1. A susceptor (10) for supporting a semiconductor wafer (12) in a heated chamber (62) having an interior space (64), the wafer (12) having a front surface (14), a back surface (16) and a circumferential edge (18), the susceptor (10) being sized and shaped for supporting the semiconductor wafer (12) within the interior space (64) of the chamber (62) **characterized by**
an upper surface (24);
a first recess (30) extending downward from the upper surface (24) and adapted to receive the semiconductor wafer (12), the first recess (30) including a generally annular first wall (32) and a first ledge (34) extending from the first wall (32) toward a center of the recess (30), the first ledge (34) having an outer perimeter and an inner perimeter, the first ledge (34) having a downward slope from the outer perimeter to the inner perimeter to facilitate supporting the wafer (12);
a second recess (40) extending downward from the first recess (30), the second recess (40) including a generally annular second wall (42) and a second ledge (44) extending inward from the second wall(42); and
a third recess (50) extending downward from the second recess (40), the third recess (50) including a generally annular third wall (52) and a floor (54) extending inward from the third wall (52), said first (30), second (40) and third recesses (50) having a common central axis (22).

2. The susceptor (10) as set forth in claim 1 wherein the distance between the back surface (16) of the wafer (12) and the floor (54) of the third recess (50) is between about 0.013 cm (0.005 inches) and about 0.076 cm (0.030 inches).

3. The susceptor (10) as set forth in claim 1 wherein the distance between the back surface (16) of the wafer (12) and the floor (54) of the third recess (50) is between about 0.020 cm (0.008 inches) and about 0.076 cm (0.030 inches).

4. The susceptor (10) as set forth in claim 1 wherein the distance between the back surface (16) of the wafer (12) and the floor (54) of the third recess (50) is between about 0.025 cm (0.010 inches) and about 0.076 cm (0.030 inches).

5. The susceptor (10) as set forth in claim 1 wherein no portion of the recesses extend through the susceptor (10) to a lower surface (26) of the susceptor (10).

6. The susceptor (10) as set forth in claim 1 wherein the ledge (44) of the second recess (40) is generally sloped or concave and wherein the vertical distance between the bottom of the generally annular second wall (42) and the top of the generally annular third wall (52) does not exceed about 0.025 cm (0.010 inches).

7. The susceptor (10) as set forth in claim 1 wherein the wafer (12) is placed on the susceptor (10) so that the circumferential edge (18) or an area of the back surface (16) adjacent the edge (18) is in contact with the first ledge (34).

8. The susceptor (10) as set forth in claim 1 wherein the recesses (30, 40, 50) are generally circular.

9. The susceptor (10) as set forth in claim 1 wherein the ratio of the surface area of the first (30) and second recesses (40) to the surface area of the floor (54) of the third recess (50) is at least about 13 to about 1 to minimize slip.

## Patentansprüche

1. Ein Suszeptor (10) zur Abstützung eines Halbleiterwafers (12) in einer Heizkammer (62) mit einem Innenraum (64), wobei der Wafer (12) eine Vorderseite (14), eine Rückseite (16) und einen Umfangsrand (18) hat, und wobei der Suszeptor (10) zur Abstützung des Halbleiterwafers (12) im Innenraum (64) der Kammer (62) bemessen und geformt ist, **gekennzeichnet durch**:
eine obere Fläche (24);
eine erste Vertiefung (30), die von der oberen Fläche (24) abwärts verläuft und ausgestaltet ist, um den Halbleiterwafer (12) aufzunehmen, die erste Vertiefung (30) mit einer generell ringförmigen ersten Wand (32) und einem ersten Absatz (34), der von der ersten Wand (32) in Richtung des Zentrums der Vertiefung (30) verläuft, wobei der erste Absatz (34) einen äußeren und einen inneren Perimeter hat, der erste Absatz (34) ein Gefälle vom äußeren Perimeter zum inneren Perimeter hat, um die Abstützung des Wafers (12) zu erleichtern;
eine zweite Vertiefung (40), die von der ersten Vertiefung (30) abwärts verläuft, die zweite Vertiefung (40) mit einer generell ringförmigen zweiten Wand (42) und einem zweiten Absatz (44), der von der zweiten Wand (42) nach innen verläuft; und
eine dritte Vertiefung (50), die von der zweiten Vertiefung (40) abwärts verläuft, die dritte Vertiefung (50) mit einer generell ringförmigen dritten Wand (52) und einen Boden (54), der von der dritten Wand (52) nach innen verläuft, wobei die erste (30), zweite (40) und dritte Vertiefung (50) eine gemeinsame zentrale Achse (22) haben.

2. Der Suszeptor (10) nach Anspruch 1, wobei der Abstand zwischen der Rückseite (16) des Wafers (12) und dem Boden (54) der dritten Vertiefung (50) zwischen etwa 0,013 cm (0,005 Zoll) und etwa 0,076 cm (0,030 Zoll) beträgt.

3. Der Suszeptor (10) nach Anspruch 1, wobei der Abstand zwischen der Rückseite (16) des Wafers (12) und dem Boden (54) der dritten Vertiefung (50) zwischen etwa 0,020 cm (0,008 Zoll) und etwa 0,076 cm (0,030 Zoll) beträgt.

4. Der Suszeptor (10) nach Anspruch 1, wobei der Abstand zwischen der Rückseite (16) des Wafers (12) und dem Boden (54) der dritten Vertiefung (50) zwischen etwa 0,025 cm (0,010 Zoll) und etwa 0,076 cm (0,030 Zoll) beträgt.

5. Der Suszeptor (10) nach Anspruch 1, wobei sich kein Teil der Vertiefungen durch den Suszeptor (10) bis zur Unterseite (26) des Suszeptors (10) erstreckt.

6. Der Suszeptor (10) nach Anspruch 1, wobei der Absatz (44) der zweiten Vertiefung (40) generell schräg oder konkav ist und wobei der vertikale Abstand zwischen dem Boden der generell ringförmigen zweiten Wand (42) und der Oberkante der generell ringförmigen dritten Wand (52) nicht mehr als etwa 0,025 cm (0,010 Zoll) beträgt.

7. Der Suszeptor (10) nach Anspruch 1, wobei der Wafer (12) auf dem Suszeptor (10) so platziert wird, dass der Umfangsrand (18) oder ein an den Rand (18) angrenzender Bereich der Rückseite (16) in Kontakt mit dem ersten Absatz (34) ist.

8. Der Suszeptor (10) nach Anspruch 1, wobei die Vertiefungen (30, 40, 50) generell kreisförmig sind.

9. Der Suszeptor (10) nach Anspruch 1, wobei das Flächenverhältnis der Oberflächen der ersten (30) und zweiten Vertiefungen (40) zur Bodenoberfläche (54) der dritten Vertiefung (50) wenigstens etwa 13 bis etwa 1 beträgt, um Slip zu minimieren.

## Revendications

1. Suscepteur (10) destiné à supporter une plaquette semi-conductrice (12) dans une chambre chauffée (62) ayant un espace intérieur (64), la plaquette (12) ayant une surface avant (14), une surface arrière (16) et un bord circonférentiel (18), le suscepteur (10) étant dimensionné et conformé pour supporter la plaquette semi-conductrice (12) dans l'espace intérieur (64) de la chambre (62), **caractérisé par** :
une surface supérieure (24),
un premier évidement (30) s'étendant vers le bas à partir de la surface supérieure (24) et adapté pour recevoir la plaquette semi-conductrice (12), le premier évidement (30) incluant une première paroi généralement annulaire (32) et un premier appui (34) s'étendant depuis la première paroi (32) vers un centre de l'évidement (30), le premier appui (34) ayant un périmètre extérieur et un périmètre intérieur, le premier appui (34) ayant une pente vers le bas du périmètre extérieur au périmètre intérieur pour faciliter le support de la plaquette (12),
un deuxième évidement (40) s'étendant vers le bas depuis le premier évidement (30), le deuxième évidement (40) incluant une seconde surface généralement annulaire (42) et un second appui (44) s'étendant vers l'intérieur depuis la deuxième paroi (42), et
un troisième évidement (50) s'étendant vers le bas depuis le deuxième évidement (40), le troisième évidement (50) incluant une troisième paroi généralement annulaire (52) et un fond (54) s'étendant vers l'intérieur depuis la troisième paroi (52), lesdits premier (30), deuxième (40) et troisième (50) évidements ayant un axe central commun (22).

2. Suscepteur (10) selon la revendication 1, dans lequel la distance entre la surface arrière (16) de la plaquette (12) et le fond (54) du troisième évidement (50) est comprise entre 0,013 cm (0,005 pouce) environ et 0,076 cm (0,030 pouce) environ.

3. Suscepteur (10) selon la revendication 1, dans lequel la distance entre la surface arrière (16) de la plaquette (12) et le fond (54) du troisième évidement (50) est comprise entre 0,020 cm (0,008 pouce) environ et 0,076 cm (0,030 pouce) environ.

4. Suscepteur (10) selon la revendication 1, dans lequel la distance entre la surface arrière (16) de la plaquette (12) et le fond (54) du troisième évidement (50) est comprise entre 0,025 cm (0,010 pouce) environ et 0,076 cm (0,030 pouce) environ.

5. Suscepteur (10) selon la revendication 1, dans lequel aucune partie des évidements ne s'étend à travers le suscepteur (10) jusqu'à une surface inférieure (26) du suscepteur (10).

6. Suscepteur (10) selon la revendication 1, dans lequel l'appui (44) du deuxième évidement (40) est généralement incliné ou concave et dans lequel la distance verticale entre le bas de la deuxième paroi généralement annulaire (42) et le haut de la troisième paroi généralement annulaire (52) ne dépasse pas 0,025 cm (0,010 pouce) environ.

7. Suscepteur (10) selon la revendication 1, dans lequel la plaquette (12) est placée sur le suscepteur (10) de telle sorte que le bord circonférentiel (18) ou une zone de la surface arrière (16) adjacente au bord (18) est en contact avec le premier appui (34).

8. Suscepteur (10) selon la revendication 1, dans lequel les évidements (30, 40, 50) sont généralement circulaires.

9. Suscepteur (10) selon la revendication 1, dans lequel le rapport entre l'aire de surface des premier (30) et deuxième (40) évidements et l'aire de surface du fond (54) du troisième évidement (50) est d'au moins 13 environ à 1 environ afin de minimiser le glissement.
